# EUROPÄISCHE PATENTSCHRIFT

(11) **EP 3 049 666 B1**
(45) Veröffentlichungstag und Bekanntmachung des Hinweises auf die Patenterteilung: **21.11.2018**
(21) Anmeldenummer: 14771307.7
(22) Anmeldetag: 19.09.2014
(51) Int. Cl.: F02M 51/06, F02M 63/00, F02M 61/16, F02M 61/08

(54) **PIEZO-INJEKTOR ZUR KRAFTSTOFF-DIREKTEINSPRITZUNG**
PIEZO INJECTOR FOR DIRECT INJECTION OF FUEL
PIEZO-INJECTEUR POUR INJECTION DIRECTE

(30) Priorität: 25.09.2013 DE 102013219225
(43) Veröffentlichungstag der Anmeldung: 03.08.2016
(73) Patentinhaber: Continental Automotive GmbH, 30165 Hannover (DE)
(72) Erfinder: SCHÜRZ, Willibald, 93188 Pielenhofen (DE)
(86) Internationale Anmeldenummer: PCT/EP2014/069999
(87) Internationale Veröffentlichungsnummer: WO 2015/044048

(56) Entgegenhaltungen:
- EP-A1- 2 317 117
- WO-A1-03/089781
- DE-A1- 19 843 570
- DE-A1-102005 063 010
- JP-A- 2010 003 980
- US-A1- 2003 127 617
- US-A1- 2010 313 853

## Beschreibung

Die Erfindung betrifft einen Piezo-Injektor zur Kraftstoff-Direkteinspritzung.

Für die Kraftstoff-Direkteinspritzung in Verbrennungsmotoren werden heute oftmals Injektoren verwendet, welche einen Piezo- oder einen Solenoid-Antrieb besitzen. Solenoid-Injektoren sind überwiegend als Mehrlochinjektoren mit nach innen öffnender Düsennadel ausgebildet, während Piezo-Injektoren oftmals einen Kegelstrahl und eine nach außen öffnende Düsennadel aufweisen. Piezo-Injektoren weisen in der Regel einen sehr aufwändigen Aufbau auf, da in einem Druckbereich von beispielsweise 5 bar bis 200 bar eine stabile Einspritzfunktion gefordert ist. Um dies erreichen zu können, ist zum Beispiel eine sogenannte druckausgeglichene Düsennadel erforderlich. Dies führt zu einer Erhöhung der Kosten. Ein wesentlicher Vorteil von Piezo-Injektoren mit nach außen öffnender Düsennadel besteht in der Gemischaufbereitungsqualität. Dies ermöglicht es, auch bei deutlich abgesenktem Einspritzdruck wie zum Beispiel 100 bar, gesetzliche Anforderungen an eine zulässige Partikelanzahl stabil über die Lebensdauer zu erfüllen. DE 1984 3570 A1 und DE 10 2005 063010 A1 offenbaren Piezo-Injektoren.

Im Vergleich zu Piezo-Injektoren sind Solenoid-Injektoren einfacher und kostengünstiger aufgebaut. Insbesondere ist keine Leerhubkompensation erforderlich. Des Weiteren besitzen Solenoid-Injektoren keine druckausgeglichene Düsennadel. Dies wirkt sich wegen der nach innen öffnenden Bewegungsrichtung, bei der ein sehr kleiner Nadelsitzdurchmesser von zum Beispiel 1,4 mm realisiert werden kann, nicht so nachteilig aus, wie bei Injektoren mit nach außen öffnenden Düsennadeln, die typischerweise Sitzdurchmesser von zirka 3,6 mm bis 4 mm aufweisen. Bei großen Einspritzdrücken von zum Beispiel 350 bar bis 500 bar entstehen aber auch bei Solenoid-Injektoren zunehmende Schwierigkeiten. Eine besondere Herausforderung bei Solenoid-Injektoren mit Mehrlochdüsen stellt die Erfüllung gesetzlicher Anforderungen an die Partikelanzahl über die gesamte Lebensdauer dar. Verschiedene Untersuchungsergebnisse zeigen, dass eine Druckanhebung von 200 bar auf 350 bis 500 bar die Partikelanzahl signifikant und stabil über die Lebensdauer reduziert. Andererseits werden die Kosten des Einspritzsystems damit aber auch stark erhöht.

Der Erfindung liegt die Aufgabe zugrunde, einen verbesserten Injektor zur Kraftstoff-Direkteinspritzung anzugeben, der sich durch eine hohe Robustheit auszeichnet und vergleichsweise einfach und kostengünstig herstellbar ist.

Diese Aufgabe wird durch einen Piezo-Injektor zur Kraftstoff-Direkteinspritzung gemäß dem unabhängigen Patentanspruch gelöst. Vorteilhafte Ausgestaltungen und Weiterbildungen der Erfindung sind Gegenstand der abhängigen Ansprüche.

Gemäß zumindest einer Ausgestaltung umfasst der Piezo-Injektor einen Injektorkörper. Der Injektorkörper bildet zumindest bereichsweise das Gehäuse des Piezo-Injektors aus und kann als Hohlzylinder, insbesondere aus Stahl, ausgebildet sein.

Weiterhin umfasst der Piezo-Injektor eine Aktuatoreinheit, die einen piezoelektrischen Aktuator aufweist. Der piezoelektrische Aktuator kann insbesondere einen Piezostack aufweisen. Der piezoelektrische Aktuator weist eine Kopfplatte und eine Bodenplatte auf. Der piezoelektrische Aktuator ist von einem Wellrohr umgeben, dass derart zwischen der Kopfplatte und der Bodenplatte eingespannt ist, dass es den piezoelektrischen Aktuator mit einer Vorspannung versieht. Vorzugsweise sind die Kopfplatte und die Bodenplatte des piezoelektrischen Aktuators mit gegenüberliegenden Enden des Wellrohrs verschweißt. Durch das Wellrohr wird der piezoelektrische Aktuator vorteilhaft verkapselt. Insbesondere ist der piezoelektrische Aktuator im Inneren des Wellrohres angeordnet, wobei ein Ende des Wellrohrs fest mit der Kopfplatte verschweißt und das andere Ende fest mit der Bodenplatte verschweißt ist. Auf diese Weise wird vorteilhaft insbesondere erreicht, dass der piezoelektrische Aktuator hermetisch dicht gegenüber Kraftstoff abgedichtet ist.

Weiterhin umfasst der Piezo-Injektor einen hydraulischen Koppler, der einen Kopplerkolben, einer Kopplerzylinder und eine Kopplerfeder aufweist.

Weiterhin umfasst der Piezo-Injektor eine Düseneinheit, die eine in einem Düsenkörper angeordnete Düsennadel aufweist. Der Kopplerkolben wird mittels der Kopplerfeder gegen eine dem Kopplerkolben zugewandte Stirnseite der Düsennadel gedrückt. Auf diese Weise wird eine spielfreie Kraftübertragung von dem piezoelektrischen Aktuator über den hydraulischen Koppler auf die Düsennadel gewährleistet. Das Wellrohr der Aktuatoreinheit ist vorzugweise aus einem sogenannten Maraging-Stahl gebildet. Der Begriff Maraging ist eine Zusammenfassung der englischen Worte Martensit und Aging und wird regelmäßig verwendet für Martensit-aushärtbaren Stahl. Das Wellrohr kann beispielsweise aus einem Hohlzylinderteil aus einem Maraging-Stahl hergestellt werden. Dabei wird das Hohlzylinderteil auf eine vorgegebene erste Temperatur erwärmt, bei der der Maraging-Stahl in einem austenitischen Zustand ist. Gemäß einer vorteilhaften Ausgestaltung liegt die erste Temperatur in einem Bereich zwischen 700 bis 950 °C. In diesem Temperaturbereich ist vorteilhaft das plastische Verformungsvermögen sehr hoch, beispielsweise größer als 30 %. Das Wellrohr wird anschließend abgekühlt und zwar derart, dass der Maraging-Stahl in einem martensitischen Zustand ist. Durch das Abkühlen des Wellrohrs, derart, dass der Maraging-Stahl in dem martensitischen Zustand ist, und zwar insbesondere größtenteils in dem martensitischen Zustand ist, kann vorteilhaft eine sehr hohe Festigkeit erreicht werden.

Gemäß einer vorteilhaften Ausgestaltung wird nach dem Umformprozess das Wellrohr zunächst abgekühlt, bis eine vorgegebene Bedingung erfüllt ist. Die vorgegebene Bedingung kann beispielsweise erfüllt sein, wenn eine vorgegebene zweite Temperatur in etwa erreicht wird, die beispielsweise in etwa einer Raumtemperatur entsprechen kann. Anschließend wird das Wellrohr wieder erwärmt und in einem vorgegebenen Temperaturbereich für eine vorgegebene Zeitdauer gealtert. Die Zeitdauer kann beispielsweise in einem Bereich von zwei bis vier Stunden liegen. Besonders vorteilhaft liegt der vorgegebene Temperaturbereich zum Altern zwischen 400 °C und 500 °C, insbesondere zwischen 450 °C und 480 °C. Nach dem erstmaligen Abkühlen auf die zweite Temperatur, die insbesondere in etwa der Raumtemperatur entspricht, klappt das Gitter des Maraging-Stahls größtenteils in den martensitischen Zustand um. Durch das Altern, das auch als Auslagern bezeichnet wird, wird die Martensitbildung vervollständigt und es kann eine besonders hohe Festigkeit erreicht werden, die beispielsweise Werte ≥ 2000 MPa aufweisen kann.

Die Kopfplatte der Aktuatoreinheit umfasst gemäß einer Ausgestaltung eine Zuführleitung für Kraftstoff, durch die Kraftstoff unter Hochdruck dem Piezo-Injektor zugeführt wird. Weiterhin umfasst die Kopfplatte vorteilhaft eine Zuführung elektrischer Anschlüsse von einem elektrischen Stecker zu dem piezoelektrischen Aktuator.

Der Kopplerzylinder der hydraulischen Kopplereinheit ist in der Bodenplatte des piezoelektrischen Aktuators ausgebildet. Auf diese Weise ist der piezoelektrische Aktuator vorteilhaft direkt mit dem hydraulischen Koppler verbunden. In dem Kopplerzylinder ist der Kopplerkolben, welcher zur Reduzierung der bewegten Massen vorteilhaft hohlgebohrt ist, mit einem geeigneten Paarungsspiel eingesetzt. Um ein geeignetes dynamisches Übertragungsverhalten des Kopplers zu erzielen, beträgt das Paarungsspiel vorzugsweise zwischen 2 µm und 6 µm.

In dem Piezo-Injektor ist vorteilhaft kein Dichtmaterial aus einem Kunststoff enthalten. Dichtungen auf Kunststoffbasis, insbesondere aus Elastomeren, werden bei herkömmlichen Piezo-Injektoren üblicherweise dazu eingesetzt, den piezoelektrischen Aktuator abzudichten. Solche auf Kunststoff basierende Dichtungen sind bei dem hierin beschriebenen Piezo-Injektor vorteilhaft nicht erforderlich, da der piezoelektrische Aktuator durch das Wellrohr und die mit dem Wellrohr fest verbundene Kopfplatte und Bodenplatte ausschließlich durch metallische Teile abgedichtet ist. Der piezoelektrische Aktuator ist daher gegenüber Kraftstoff unter Hochdruck besonders robust abgedichtet.

Der Injektorkörper ist gemäß einer vorteilhaften Ausgestaltung ein einstückiges Rohrstück, welches an einer Seite mit der Kopfplatte und an einer gegenüberliegenden Seite mit dem Düsenkörper fest verbunden, insbesondere verschweißt ist. Gemäß einer Ausgestaltung ist die Düsennadel der Düseneinheit als nach außen öffnende Düsennadel ausgeführt. Der Nadelsitz der Düsennadel ist vorzugsweise als Kegelmantelfläche ausgeführt, welche im Düsenkörper gegen eine Hohlkegelfläche gedrückt wird und so die Dichtfunktion erreicht wird.

Zur Erzeugung einer auf die Düsennadel wirkenden Schließkraft weist die Düseneinheit vorzugsweise eine Düsenfeder auf. Die Düsenfeder ist vorzugsweise an einer Seite an dem Düsenkörper befestigt und drückt an einer anderen Seite gegen einen an der Düsennadel angebrachten, insbesondere auf die Düsennadel aufgepressten, Federteller. Auf diese Weise wird die von der Düsenfeder erzeugte Dichtkraft auf die Düsennadel übertragen.

Gemäß einer vorteilhaften Ausgestaltung ist in dem hydraulischen Koppler ein Kraftstofffilm, insbesondere ein sehr dünner Kraftstofffilm, angeordnet. Der Kraftstofffilm befindet sich vorteilhaft zwischen einer Stirnseite des Kopplerkolbens und einer dem Kopplerkolben zugewandten Stirnseite der Bodenplatte der Aktuatoreinheit, in welcher vorteilhaft der Kopplerzylinder ausgebildet ist. Die Dicke dieser dünnen Kraftstoffschicht wird vorteilhaft so klein wie möglich gewählt, sodass der hydraulische Koppler eine möglichst große Steifigkeit aufweist. Die minimale Dicke der Schicht wird bestimmt durch die erforderlichen Montagetoleranzen und die Längenänderungsunterschiede zwischen dem piezoelektrischen Aktuator und dem Injektorkörper bei Temperaturänderung infolge der unterschiedlichen Wärmeausdehnungskoeffizienten zwischen dem piezoelektrischen Aktuator und dem Material des Injektorkörpers, insbesondere Stahl. Die Schichtdicke der dünnen Kraftstoffschicht liegt vorteilhaft im Bereich von 0,05 mm bis 0,3 mm.

Der Injektorkörper besteht bei einer bevorzugten Ausgestaltung aus einem einstückig ausgebildeten Rohrstück, welches an einer Oberseite an die Kopfplatte des piezoelektrischen Aktuators und an einer Unterseite an den Düsenkörper angeschweißt ist. Im Zuge des Montageprozesses des Injektorkörpers kann die Schichtdicke der Kraftstoffschicht in dem hydraulischen Koppler eingestellt werden.

Der hierin beschriebene Piezo-Injektor zeichnet sich insbesondere dadurch aus, dass Längenänderungen infolge von Temperatureffekten, Verschleiß an Kontaktstellen und/oder einer Änderung des Polarisationszustands des piezoelektrischen Aktuators ausgeglichen werden. Der piezoelektrische Aktuator weist vorteilhaft keinen Leerhub auf, wodurch sich die Ansteuerenergie reduziert und aufwändige Einstellprozesse für den Leerhub während der Montage des Piezo-Injektors entfallen können.

Der Piezo-Injektor zeichnet sich weiterhin durch einen sehr einfachen Montageprozess aus, wodurch die Fertigungskosten reduziert werden. Bei dem beschriebenen Piezo-Injektor ist die Einspritzmenge im dynamischen Motorbetrieb vorteilhaft äußerst stabil. Durch die Verwendung von ausschließlich metallischen Dichtungen sind Druckverluste im Injektor minimiert und der piezoelektrische Aktuator besonders zuverlässig gegenüber Kraftstoff abgedichtet.

Weitere vorteilhafte Ausgestaltungen und Vorteile des Piezo-Injektors ergeben sich aus der folgenden Beschreibung eines Ausführungsbeispiels anhand der Figuren 1 bis 3.

Es zeigen:
- Figur 1: eine schematische Darstellung eines Querschnitts durch einen Piezo-Injektor gemäß einem Ausführungsbeispiel,
- Figur 2: eine Außenansicht des Wellrohrs bei dem Ausführungsbeispiel, und
- Figur 3: eine vergrößerte Darstellung eines Teilbereichs des in Figur 2 dargestellten Wellrohrs.

Die dargestellten Bestandteile sowie die Größenverhältnisse der Bestandteile untereinander sind nicht als maßstabsgerecht anzusehen.

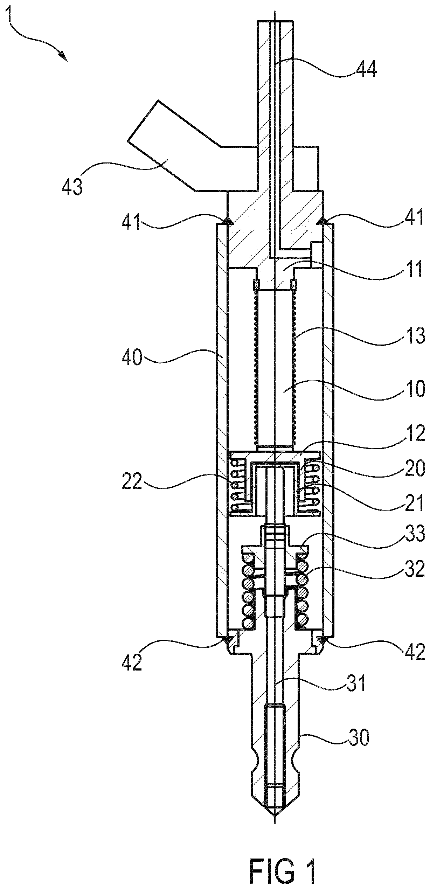

Der in Figur 1 schematisch im Querschnitt dargestellte Piezo-Injektor 1 enthält einen piezoelektrischen Aktuator 10, der insbesondere einen Piezo-Stack aufweisen kann. Der piezoelektrische Aktuator 10 ist vorteilhaft innerhalb eines Wellrohrs 13 angeordnet, das mit einer Kopfplatte 11 und einer Bodenplatte 12 des piezoelektrischen Aktuators 10 verschweißt ist. Der piezoelektrische Aktuator 10 wird auf diese Weise durch ausschließlich metallische Dichtungen gegenüber Kraftstoff abgedichtet. Insbesondere werden keine Dichtungen aus Kunststoffen wie beispielsweise Membranen aus Elastomeren verwendet. Hierdurch wird eine besonders robuste und zuverlässige Abdichtung des piezoelektrischen Aktuators 10 erzielt.

Das Wellrohr 13 ist vorteilhaft aus einem Maraging-Stahl hergestellt. Maraging-Stähle sind vorteilhaft hochfest und weisen eine hohe Festigkeit und eine gute Zähigkeit auf. Sie umfassen im Wesentlichen kohlenstofffreie Legierungen und sind mit einem hohen Anteil von Nickel, beispielsweise größer als 12 %, legiert. Sie enthalten gegebenenfalls auch weitere Legierungselemente, wie beispielsweise Aluminium, Molybdän, Kupfer, Niob, Kobalt und/oder Titan.

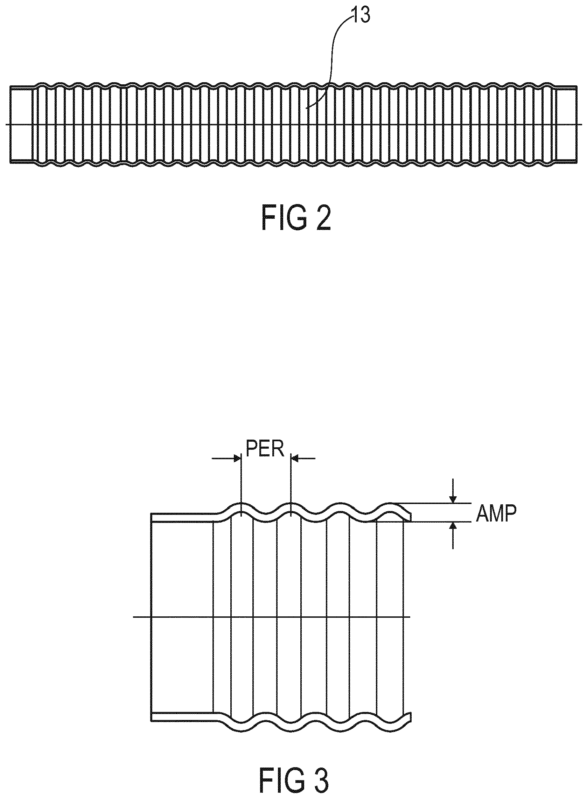

Das Wellrohr 13 ist in Figur 2 in einer Außenansicht und in Figur 3 in einer vergrößerten Detailansicht dargestellt. Die Ausformung der Wellen des Wellrohrs 13 ist so gewählt, dass eine gewünschte Federkonstante erreicht wird, ohne die zulässigen Spannungen zum Erreichen einer vorgegebenen Festigkeit über die Lebensdauer zu überschreiten. Als Designparameter für das Wellrohr 13 stehen insbesondere die Wandstärke, die Periode PER und die Amplitude AMP der Wellen zur Verfügung. Beispielsweise ergibt sich bei einem Außendurchmesser des Wellrohrs 13 von 9,2 mm, einer Wanddicke von 0,2 mm, einer Wellenamplitude AMP von 0,4 mm und einer Wellenperiode PER von 2 mm eine Federkonstante von 1, 8 N/mm und eine mögliche Vorspannkraft von 800 N bei einer Länge des Wellrohrs 13 von 63 mm.

Zum Erzielen einer vorgegebenen Vorspannung, beispielsweise von etwa 800 N, wird das Wellrohr 13 derart zwischen der Kopfplatte 11 und der Bodenplatte 12 fixiert, dass der piezoelektrische Aktuator 10 mit einer vorgegebenen Vorspannung zwischen der Kopfplatte 11 und der Bodenplatte 12 eingespannt ist. Das Fixieren der Kopfplatte 11 und der Bodenplatte 12 kann beispielsweise mittels Schweißens, insbesondere mittels Laserschweißens, erfolgen. Das Wellrohr 13 wird insbesondere derart mit der Kopfplatte 11 und der Bodenplatte 12 verbunden, dass der piezoelektrische Aktuator 10 hermetisch dicht von der Umgebung abgedichtet ist.

Die Kopfplatte 11 umfasst vorteilhaft eine Zuführung von elektrischen Anschlüssen von einem elektrischen Stecker 43 zu dem piezoelektrischen Aktuator 10. Weiterhin umfasst die Kopfplatte 11 vorteilhaft eine Kraftstoff-Zuführung 44 zur Zuführung von Kraftstoff unter Hochdruck.

Die Kraftübertragung von dem piezoelektrischen Aktuator 10 auf eine Düsennadel 31 erfolgt mittels eines hydraulischen Kopplers, der einen Kopplerzylinder 20, einen Kopplerkolben 21 und eine Kopplerfeder 22 umfasst. Der Kopplerzylinder 20 ist vorteilhaft in der Bodenplatte 12 des piezoelektrischen Aktuators 10 ausgebildet. Die Bodenplatte 12 und der Kopplerzylinder 20 können also aus einem einzigen Metallstück geformt sein. In dem Kopplerzylinder 20 ist der Kopplerkolben 21 mit einem geeigneten Paarungsspiel eingesetzt, wobei das Paarungsspiel zur Erzielung eines geeigneten dynamischen Übertragungsverhaltens des hydraulischen Kopplers vorzugsweise in einem Bereich von 2 µm bis 6 µm gewählt wird.

Der Kopplerkolben 21 kann insbesondere hohlgebohrt sein, um die bewegte Masse zu reduzieren. Der Kopplerkolben 21 wird mittels einer Kopplerfeder 22 gegen eine Stirnseite der Düsennadel 31 gedrückt. Auf diese Weise wird eine Spielfreiheit des Antriebes gewährleistet. Bei dem Ausführungsbeispiel der Figur 1 ist die Kopplerfeder 22 zwischen dem Kopplerzylinder 20 und dem Injektorkörper 40 angeordnet, welcher die äußere Ummantelung des Piezo-Injektors 1 ausbildet. Alternativ wäre es auch möglich, die Kopplerfeder 22 im Inneren des Kopplerkolbens 21, insbesondere im Zwischenraum zwischen der dem Kopplerkolben 21 zugewandten Mantelfläche der Düsennadel 31 und dem Kopplerkolben 21 anzuordnen.

In dem hydraulischen Koppler befindet sich vorteilhaft zwischen einer der Bodenplatte 12 zugewandten Stirnseite des Kopplerkolbens 21 und der gleichzeitig als Kopplerzylinder 20 ausgebildeten Bodenplatte 12 eine vorzugsweise dünne Kraftstoffschicht (nicht dargestellt). Die Dicke dieser dünnen Kraftstoffschicht wird so klein wie möglich gewählt, um eine möglichst große Steifigkeit des Kopplers zu erzielen. Eine minimale Dicke dieser dünnen Kraftstoffschicht wird bestimmt durch die erforderlichen Montagetoleranzen und die Unterschiede in der Längenausdehnung zwischen dem piezoelektrischen Aktuator 10 und dem Injektorkörper 40 bei Temperaturänderungen infolge ihrer unterschiedlichen Wärmeausdehnungskoeffizienten. Die Schichtdicke der Kraftstoffschicht liegt vorteilhaft in einem Bereich von 0,05 mm bis 0,3 mm.

Die Düsennadel 31 des Piezo-Injektors 1 ist eine nach außen öffnende Düsennadel, die in einem Düsenkörper 30 geführt ist. Der Nadelsitz der Düsennadel 31 kann beispielsweise als Kegelmantelfläche ausgeführt sein, welche im Düsenkörper 30 gegen eine Hohlkegelfläche gedrückt wird, um die Dichtfunktion zu erreichen. Eine auf die Düsennadel 31 wirkende Dichtkraft wird durch eine Düsenfeder 32 erzeugt, welche zwischen dem Düsenkörper 30 und einem mit der Düsennadel 31 verbundenen Federteller 33 eingespannt ist. Der Federteller 33 kann insbesondere auf die Düsennadel 31 aufgepresst sein.

Die Federkraft der Düsenfeder 32 wird vorteilhaft so eingestellt, dass eine resultierende Kraft, die sich aus der Düsenfederkraft abzüglich der hydraulisch wirkenden Nadelöffnungskraft und abzüglich einer Kontaktkraft des hydraulischen Kopplers bei maximal zulässigem Einspritzdruck (Rail-Druck) noch eine ausreichende Nadelsitzkraft sicherstellt. Die hydraulisch wirkende Nadelöffnungskraft kann aus der Querschnittsfläche des Nadelsitzes und dem Einspritzdruck berechnet werden, und die Kontaktkraft des hydraulischen Kopplers entspricht der Federkraft der Kopplerfeder 22. Die resultierende Nadelsitzkraft wird bei maximal zulässigem Einspritzdruck vorteilhaft im Bereich von 20 N bis 50 N eingestellt.

Der Injektorkörper 40 des Piezo-Injektors 1 bildet bereichsweise eine äußere Ummantelung des Piezo-Injektors 1 aus und kann insbesondere aus Stahl gefertigt sein. Vorzugsweise ist der Injektorkörper 40 einstückig ausgebildet, insbesondere aus einem Rohrstück. Der Injektorkörper 40 kann insbesondere an einer Seite mittels einer Schweißnaht 41 mit der Kopfplatte 11 des piezoelektrischen Aktuators 10 verschweißt sein, und an der gegenüberliegenden Seite mittels einer Schweißnaht 42 mit dem Düsenkörper 30 verschweißt sein. Während des Montageprozesses des Injektorkörpers 40 kann die Schichtdicke der dünnen Kraftstoffschicht in dem Kopplerkolben 21 eingestellt werden. Der so aufgebaute Piezo-Injektor 1 zeichnet sich insbesondere dadurch aus, dass er vergleichsweise einfach herstellbar und sehr robust ist.

## Patentansprüche

1. Piezo-Injektor (1) zur Kraftstoff-Direkteinspritzung, umfassend:
- einen Injektorkörper (40),
- eine Aktuatoreinheit, aufweisend einen piezoelektrischen Aktuator (10) mit einer Kopfplatte (11) und einer Bodenplatte (12), wobei der piezoelektrische Aktuator (10) von einem Wellrohr (13) umgeben ist, welches derart zwischen der Kopfplatte (11) und der Bodenplatte (12) eingespannt ist, dass der piezoelekrische Aktuator (10) mit einer Vorspannung versehen ist,
- einen hydraulischen Koppler, aufweisend einen Kopplerkolben (21), einen Kopplerzylinder (20) und eine Kopplerfeder (22), und
- eine Düseneinheit, aufweisend eine in einem Düsenkörper (30) angeordnete Düsennadel (31), wobei der Kopplerkolben (21) mittels der Kopplerfeder (22) gegen eine dem Kopplerkolben (21) zugewandte Stirnseite der Düsennadel (31) gedrückt wird, **dadurch gekennzeichnet dass** der Kopplerzylinder (20) in der Bodenplatte (12) des piezoelektrischen Aktuators (10) ausgebildet ist.

2. Piezo-Injektor nach Anspruch 1,
wobei das Wellrohr (13) einen Maraging-Stahl aufweist.

3. Piezo-Injektor nach einem der vorhergehenden Ansprüche,
wobei in dem Piezo-Injektor (1) ausschließlich metallisches Dichtmaterial enthalten ist.

4. Piezo-Injektor nach einem der vorhergehenden Ansprüche,
wobei der Injektorkörper (40) ein einstückiges Rohrstück ist, welches an einer Seite mit der Kopfplatte (11) und an einer gegenüberliegenden Seite mit dem Düsenkörper (30) fest verbunden ist.

5. Piezo-Injektor nach einem der vorhergehenden Ansprüche,
wobei die Düsennadel (31) nach außen öffnend ausgeführt ist.

6. Piezo-Injektor nach einem der vorhergehenden Ansprüche,
wobei die Düseneinheit eine Düsenfeder (32) zur Erzeugung einer auf die Düsennadel (31) wirkenden Schließkraft aufweist.

7. Piezo-Injektor nach Anspruch 6,
wobei die Düsenfeder (32) an einer Seite an dem Düsenkörper (30) befestigt ist und an einer anderen Seite gegen einen an der Düsennadel (31) angebrachten Federteller (33) drückt.

8. Piezo-Injektor nach einem der vorhergehenden Ansprüche,
wobei in dem hydraulischen Koppler ein Kraftstofffilm angeordnet ist.

9. Piezo-Injektor nach Anspruch 8,
wobei der Kraftstofffilm eine Dicke im Bereich von 0,05 mm bis 0,3 nm aufweist.

## Claims

1. Piezo injector (1) for direct fuel injection, comprising:
- an injector body (40),
- an actuator unit having a piezoelectric actuator (10) with a head plate (11) and with a base plate (12), wherein the piezoelectric actuator (10) is surrounded by a corrugated tube (13) which is braced between the head plate (11) and the base plate (12) such that the piezoelectric actuator (10) has a preload imparted to it,
- a hydraulic coupler having a coupler piston (21), a coupler cylinder (20) and a coupler spring (22), and
- a nozzle unit having a nozzle needle (31) arranged in a nozzle body (30), wherein, by way of the coupler spring (22), the coupler piston (21) is forced against a face side, facing toward the coupler piston (21), of the nozzle needle (31), **characterized in that** the coupler cylinder (20) is formed in the base plate (12) of the piezoelectric actuator (10).

2. Piezo injector according to Claim 1,
wherein the corrugated tube (13) has a maraging steel.

3. Piezo injector according to one of the preceding claims,
wherein the piezo injector (1) comprises exclusively metallic sealing material.

4. Piezo injector according to one of the preceding claims,
wherein the injector body (40) is a unipartite tube piece which is fixedly connected at one side to the head plate (11) and at an opposite side to the nozzle body (30).

5. Piezo injector according to one of the preceding claims,
wherein the nozzle needle (31) is of outwardly opening design.

6. Piezo injector according to one of the preceding claims,
wherein the nozzle unit has a nozzle spring (32) for generating a closing force which acts on the nozzle needle (31) .

7. Piezo injector according to Claim 6,
wherein the nozzle spring (32), at one side, is fastened to the nozzle body (30) and, at the other side, presses against a spring plate (33) which is attached to the nozzle needle (31).

8. Piezo injector according to one of the preceding claims,
wherein a fuel film is arranged in the hydraulic coupler.

9. Piezo injector according to Claim 8,
wherein the fuel film has a thickness in the range from 0.05 mm to 0.3 mm.

## Revendications

1. Injecteur piézoélectrique (1) pour une injection directe de carburant, comprenant :
- un corps d'injecteur (40),
- une unité d'actionneur présentant un actionneur piézoélectrique (10) avec une plaque de tête (11) et une plaque de fond (12), l'actionneur piézoélectrique (10) étant entouré d'un tube ondulé (13) qui est serré entre la plaque de tête (11) et la plaque de fond (12) de telle sorte que l'actionneur piézoélectrique (10) soit soumis à une précontrainte,
- un coupleur hydraulique, présentant un piston de coupleur (21), un cylindre de coupleur (20) et un ressort de coupleur (22), et
- une unité de buse présentant une aiguille de bus (31) disposée dans un corps de bus (30), le piston de coupleur (21) étant pressé au moyen du ressort de coupleur (22) contre un côté frontal de l'aiguille de buse (31) tourné vers le piston de coupleur (21), **caractérisé en ce que** le cylindre de coupleur (20) est réalisé dans la plaque de fond (12) de l'actionneur piézoélectrique (10).

2. Injecteur piézoélectrique selon la revendication 1, dans lequel le tube ondulé (13) présente un acier maraging.

3. Injecteur piézoélectrique selon l'une quelconque des revendications précédentes, dans lequel un matériau d'étanchéité exclusivement métallique est contenu dans l'injecteur piézoélectrique (1).

4. Injecteur piézoélectrique selon l'une quelconque des revendications précédentes, dans lequel le corps d'injecteur (40) est une pièce tubulaire monobloc qui est connectée fixement au niveau d'un côté à la plaque de tête (11) et au niveau d'un côté opposé au corps de buse (30).

5. Injecteur piézoélectrique selon l'une quelconque des revendications précédentes, dans lequel l'aiguille de buse (31) est réalisée de manière à ouvrir vers l'extérieur.

6. Injecteur piézoélectrique selon l'une quelconque des revendications précédentes, dans lequel l'unité de buse présente un ressort de buse (32) pour générer une force de fermeture agissant sur l'aiguille de buse (31).

7. Injecteur piézoélectrique selon la revendication 6, dans lequel le ressort de buse (32) est fixé d'un côté au corps de buse (30) et d'un autre côté presse contre une coupelle de ressort (33) montée sur l'aiguille de buse (31).

8. Injecteur piézoélectrique selon l'une quelconque des revendications précédentes, dans lequel un film en plastique est disposé dans le coupleur hydraulique.

9. Injecteur piézoélectrique selon la revendication 8, dans lequel le film en plastique présente une épaisseur comprise entre 0,05 mm et 0,3 nm.
